# EUROPEAN PATENT SPECIFICATION

(11) **EP 4 726 776 B1**
(45) Date of publication and mention of the grant of the patent: **04.11.2026**
(21) Application number: 25181614.6
(22) Date of filing: 09.06.2025
(51) Int. Cl.: H10W 70/60, H10W 70/65, H10W 90/00, H10W 70/05, H10W 70/40, H10W 70/685

(54) **SEMICONDUCTOR PACKAGE**
HALBLEITERGEHÄUSE
BOÎTIER DE SEMI-CONDUCTEUR

(30) Priority: 10.10.2024 KR 20240137932
(43) Date of publication of application: 15.04.2026
(73) Proprietor: Samsung Electronics Co., Ltd., Suwon-si, Gyeonggi-do 16677 (KR)
(72) Inventor: PARK, Eunkyeong, 16677 Suwon-si (KR); SONG, Sang Sub, 16677 Suwon-si (KR); YONG, Seokbeom, 16677 Suwon-si (KR)
(74) Representative: Marks & Clerk LLP

(56) References cited:
- US-A1- 2018 158 771
- US-A1- 2018 374 804
- US-A1- 2021 082 822

## Description

### BACKGROUND OF THE INVENTION

The present invention relates to a semiconductor package.

With the rapid advancement of the electronics industry and the increasing demands of users, electronic devices are becoming increasingly smaller, more multifunctional, and higher in capacity, and thus, a semiconductor package including a plurality of semiconductor chips is being required. In the case where the number of semiconductor chips in a semiconductor package increases, there are difficulties in placing many semiconductor chips in a printed circuit board. In order to alleviate these difficulties, a semiconductor package including an interposer, which is used to connect the semiconductor chips to each other, is being developed. US 2021/082822 A1 discloses an electronic interposer may be formed comprising an upper section, a lower section and a middle section. The upper section and the lower section may each have between two and four layers, wherein each layer comprises an organic material layer and at least one conductive route comprising at least one conductive trace and at least one conductive via. The middle section may be formed between the upper section and the lower section, wherein the middle section comprises up to eight layers, wherein each layer comprises an organic material and at least one conductive route comprising at least one conductive trace and at least one conductive via, and wherein a thickness of each layer of the middle section is thinner than a thickness of any of the layers of the upper section and thinner than a thickness of any of the layers of the lower section.
US 2018/158771 A1 discloses in an interposer, a plurality of wiring layers are disposed between uppermost-layer wiring and lowermost-layer wiring. For example, a third wiring layer is electrically coupled directly to a first wiring layer as the uppermost-layer wiring by a long via wire extending through insulating layers without intervention of a second wiring layer. For example, an upper-surface terminal made of the first wiring layer is electrically coupled directly to a via land made of the third wiring layer by the long via wire. Between the adjacent long via wires, three lead-out wires made of the second wiring layer can be placed. The number of the lead-out wires that can be placed between the adjacent long via wires is larger than the number of the lead-out wires that can be placed between the adjacent via lands.
US 2018/374804 A1 discloses a ground isolation transmission line package device that includes (1) ground isolation planes between, (2) ground isolation lines surrounding, or (3) such ground planes between and such ground isolation lines surrounding horizontal data signal transmission lines (e.g., metal signal traces) that are horizontally routed through the package device. The (1) ground isolation planes between, and/or (2) ground isolation lines electrically shield the data signals transmitted in signal lines, thus reducing signal crosstalk between and increasing electrical isolation of the data signal transmission lines. In addition, data signal transmission lines may be tuned using eye diagrams to select signal line widths and ground isolation line widths that provide optimal data transmission performance.

### SUMMARY

An embodiment of the inventive concept provides a semiconductor package with an improved signal quality.

An embodiment of the inventive concept provides a semiconductor package with an increased density of signal lines.

An aspect of the invention is described at Claim 1. According to an embodiment of the inventive concept, a semiconductor package may include a wiring substrate including a plurality of interconnection layers. The plurality of interconnection layers may include a first interconnection layer and a second interconnection layer on the first interconnection layer. The first interconnection layer may include first conductive lines, which include two first ground lines spaced apart from each other in a first direction and two first signal lines interposed therebetween, and which extend lengthwise in a second direction perpendicular to the first direction. The second interconnection layer may include second conductive lines including a second signal line A, which is adjacent to one of the first signal lines in a third direction perpendicular to the first and second directions, and a second ground line A, which is adjacent to another of the first signal lines in the third direction. The second conductive lines may extend lengthwise in the second direction.

According to an embodiment of the inventive concept, a semiconductor package may include a wiring substrate including a plurality of interconnection layers. The plurality of interconnection layers may include a first interconnection layer and a second interconnection layer on the first interconnection layer. The first interconnection layer may include first pads, which are spaced apart from each other in a first direction, and first conductive lines, which are disposed between the first pads and are arranged in the first direction. The second interconnection layer may include second pads, which are spaced apart from each other in the first direction, and second conductive lines, which are disposed between the second pads and are arranged in the first direction. Each of the first and second conductive lines may extend lengthwise in a second direction perpendicular to the first direction. The first conductive lines may include first ground lines and first signal lines arranged along a first arrangement pattern, and the second conductive lines may include second ground lines and second signal lines arranged along a second arrangement pattern. The first arrangement pattern may be a pattern, in which the first ground line, the first signal line, the first signal line, and the first ground line are repeatedly arranged in the first direction. A number of the second signal lines in the second interconnection layer may be different from a number of the first signal lines in the first interconnection layer.

According to an embodiment of the inventive concept, a semiconductor package may include a package substrate, an interposer on the package substrate, and a first semiconductor chip and a second semiconductor chip on the interposer. The interposer may include a wiring substrate including a plurality of interconnection layers. The plurality of interconnection layers may include a first interconnection layer and a second interconnection layer on the first interconnection layer. The first interconnection layer may include first conductive lines, which include two first ground lines spaced apart from each other in a first direction and two first signal lines interposed therebetween and which extend lengthwise in a second direction perpendicular to the first direction. The second interconnection layer may include second conductive lines including a second signal line, which is adjacent to one of the first signal lines in a third direction perpendicular to the first and second directions, and a second ground line, which is adjacent to another of the first signal lines in the third direction. The second conductive lines may extend lengthwise in the second direction, and the first and second semiconductor chips may be spaced apart from each other in the second direction.

At least some of the above and other features of the invention are set out in the claims.

### BRIEF DESCRIPTION OF THE DRAWINGS

FIG. 1 is a sectional view illustrating a portion of a semiconductor package according to an example embodiment of the inventive concept.
FIG. 2 is an enlarged view illustrating a portion 'EG1' of FIG. 1.
FIG. 3 is a sectional view illustrating a portion of a semiconductor package according to an example embodiment of the inventive concept.
FIG. 4 is an enlarged view illustrating a portion 'EG2' of FIG. 3.
FIG. 5 is a sectional view illustrating a portion of a semiconductor package according to an example embodiment of the inventive concept.
FIG. 6 is a sectional view illustrating a portion of a semiconductor package according to an example embodiment of the inventive concept.
FIG. 7 is a sectional view illustrating a portion of a semiconductor package according to an example embodiment of the inventive concept.
FIG. 8 is an enlarged view corresponding to the portion 'EG1' of FIG. 1.
FIG. 9 is an enlarged view corresponding to the portion 'EG1' of FIG. 1.
FIG. 10 is an enlarged view corresponding to the portion 'EG2' of FIG. 3.
FIG. 11 is an enlarged view corresponding to the portion 'EG2' of FIG. 3.
FIG. 12 is an enlarged view corresponding to the portion 'EG1' of FIG. 1.
FIG. 13 is an enlarged view corresponding to the portion 'EG2' of FIG. 3.
FIG. 14 is a sectional view illustrating a semiconductor package according to an example embodiment of the inventive concept.
FIG. 15 is a sectional view illustrating a semiconductor package according to an example embodiment of the inventive concept.
FIG. 16 is a sectional view illustrating a semiconductor package according to an example embodiment of the inventive concept.

### DETAILED DESCRIPTION

Example embodiments of the inventive concept will now be described more fully with reference to the accompanying drawings, in which example embodiments are shown. Like reference numbers refer to like elements throughout.

In the present specification, the term "on" indicates a relative position and is defined to include cases where the described structure is located above or below the reference structure. In other words, "on" includes not only its conventional meaning of "above" but also cases where it is positioned "below."

In the present specification, the term "adjacent" with respect to a first interconnection line and a second interconnection line means that no other interconnection line is interposed between them, and that the first and second interconnection lines are either directly next to or close to each other.

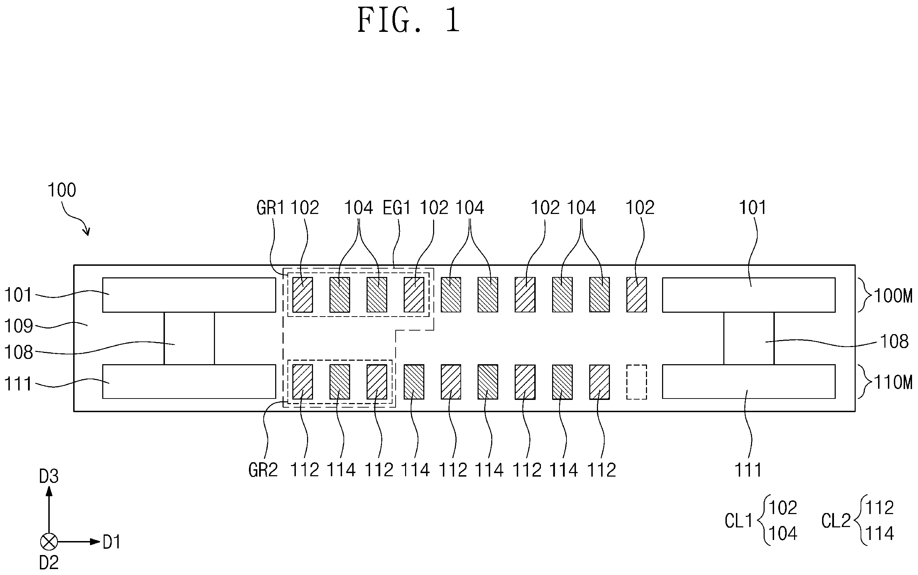

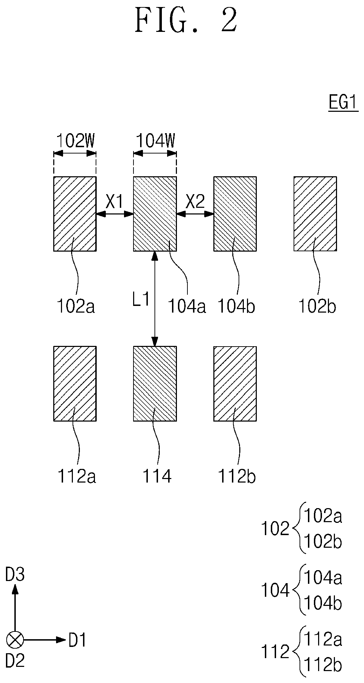

FIG. 1 is a sectional view illustrating a portion of a semiconductor package according to an example embodiment of the inventive concept. FIG. 2 is an enlarged view illustrating a portion 'EG1' of FIG. 1.

Referring to FIG. 1, a semiconductor package may include a wiring substrate 100. The wiring substrate 100 may be a substrate, on which a semiconductor chip is mounted. In the present specification, a first direction D1, a second direction D2, and a third direction D3 may be perpendicular to each other. The first and second directions D1 and D2 may be parallel to a top surface of the wiring substrate 100. The third direction D3 may be perpendicular to the top surface of the wiring substrate 100. In the present specification, a horizontal direction may mean the first direction D1 and/or the second direction D2. A vertical direction may mean the third direction D3.

The wiring substrate 100 may include a plurality of interconnection layers 100M and 110M. The interconnection layers 100M and 110M may include a first interconnection layer 100M and a second interconnection layer 110M on the first interconnection layer 100M. The first and second interconnection layers 100M and 110M may be located at different positions in the third direction D3 and may be adjacent to each other in the third direction D3.

Referring to FIG. 1, the first interconnection layer 100M includes a plurality of first conductive lines CL1. The first conductive lines CL1 includes a plurality of first ground lines 102 and a plurality of first signal lines 104, which are disposed in the first interconnection layer 100M. The plurality of first ground lines 102 and the plurality of first signal lines 104 are aligned with one another along the first direction D1. For example, upper surfaces of the plurality of first ground lines 102 and the plurality of first signal lines 104 may be at the same level, and lower surfaces of the plurality of first ground lines 102 and the plurality of first signal lines 104 may be at the same level. The first conductive lines CL1 include two first ground lines 102, which are spaced apart from each other in the first direction D1, and two first signal lines 104, which are interposed therebetween. The first conductive lines CL1 is arranged along a first arrangement pattern GR1. The first arrangement pattern GR1 includes the first ground line 102, the first signal line 104, the first signal line 104, and the first ground line 102, which are repeatedly arranged in the first direction D1. The first conductive lines CL1 may extend lengthwise in the second direction D2. The first interconnection layer 100M may further include first pads 101, which are spaced apart from each other in the first direction D1 with the first conductive lines CL1 interposed therebetween. Each of the first pads 101 and the first conductive line CL1 adjacent thereto may be, for example, the first ground lines 102.

The second interconnection layer 110M may include a plurality of second conductive lines CL2. The second conductive lines CL2 may include a plurality of second ground lines 112 and a plurality of second signal lines 114, which are disposed in the second interconnection layer 110M. The plurality of second ground lines 112 and the plurality of second signal lines 114 may be aligned with one another along the first direction D1. For example, upper surfaces of the plurality of second ground lines 112 and the plurality of second signal lines 114 may be at the same level, and lower surfaces of the plurality of second ground lines 112 and the plurality of second signal lines 114 may be at the same level. The second conductive lines CL2 may include two second ground lines 112, which are spaced apart from each other in the first direction D1, and the second signal line 114, which are interposed therebetween. The second conductive lines CL2 may be arranged along a second arrangement pattern GR2. The second arrangement pattern GR2 may be different from the first arrangement pattern GR1. The second arrangement pattern GR2 may include the second ground line 112, the second signal line 114, and the second ground line 112, which are repeatedly arranged in the first direction D1. The second conductive lines CL2 may extend lengthwise in the second direction D2. The second interconnection layer 110M may further include second pads 111, which are spaced apart from each other in the first direction D1 with the second conductive lines CL2 interposed therebetween. In an embodiment, the second conductive line CL2, which is closest to each of the second pads 111, may be the second ground lines 112. A distance from one of the second pads 111 to the second ground line 112 adjacent thereto may be smaller than a distance from another one of the second pads 111 to the second ground line 112.

Vias 108 may be interposed between the first pads 101 and the second pads 111. The first pads 101 and the second pads 111 may be electrically connected to each other through the vias 108.

The number of the second signal lines 114, which are interposed between the second pads 111 disposed adjacent to each other in the first direction D1, may be smaller than the number of the first signal lines 104, which are interposed between the first pads 101 disposed adjacent to each other in the first direction D1. For example, within a given area, the number of the second signal lines 114 may be smaller than the number of the first signal lines 104.

The first and second interconnection layers 100M and 110M may be formed of or include at least metallic materials. The first and second interconnection layers 100M and 110M may be formed of or include at least one of metallic materials (e.g., copper, aluminum, and gold).

The first and second interconnection layers 100M and 110M may be disposed on an insulating layer 109. Although the insulating layer 109 is illustrated as a single layer, the insulating layer 109 may be a plurality of insulating layers. The insulating layer 109 may include an inorganic insulating material (e.g., silicon oxide (SiO₂) and silicon nitride (SiN)) or a polymer insulating material (e.g., polyimide), depending on the type of the wiring substrate 100.

Referring to FIGS. 1 and 2, the first ground lines 102 may include a first ground line 102a and a first ground line 102b, the first signal lines 104 may include a first signal line 104a and a first signal line 104b, and the second ground lines 112 may include a second ground line 112a and a second ground line 112b. The first ground line 102a may have a first width 102W in the first direction D1, and the first signal line 104a may have a second width 104W in the first direction D1. The first and second widths 102W and 104W may be substantially equal to each other. The first and second widths 102W and 104W may range from 0.5 µm to 5 µm. Thicknesses of the first signal lines 104a and 104b and the first ground lines 102a and 102b in the third direction D3 may be substantially the same and may range from 1 µm to 5 µm. A distance L1 between the first and second interconnection layers 100M and 110M in the third direction D3 may be larger than the first and second widths 102W and 104W. When measured in the first direction D1, a first distance X1 between the first ground line 102 (e.g., first ground line 102a and first ground line 102b) and the first signal line 104 (e.g., first signal line 104a and first signal line 104b), which are adjacent to each other in the first direction D1, may be substantially equal to a second distance X2 between two adjacent ones of the first signal lines 104. For example, the first and second distances X1 and X2 may range from 0.5 µm to 5 µm.

One (e.g., the first signal line 104a) of the first signal lines 104a and 104b may be adjacent to the second signal line 114 in the third direction D3. The other (e.g., the first signal line 104b) of the first signal lines 104a and 104b may be adjacent to one (e.g., the second ground line 112b) of the second ground lines 112a and 112b in the third direction D3.

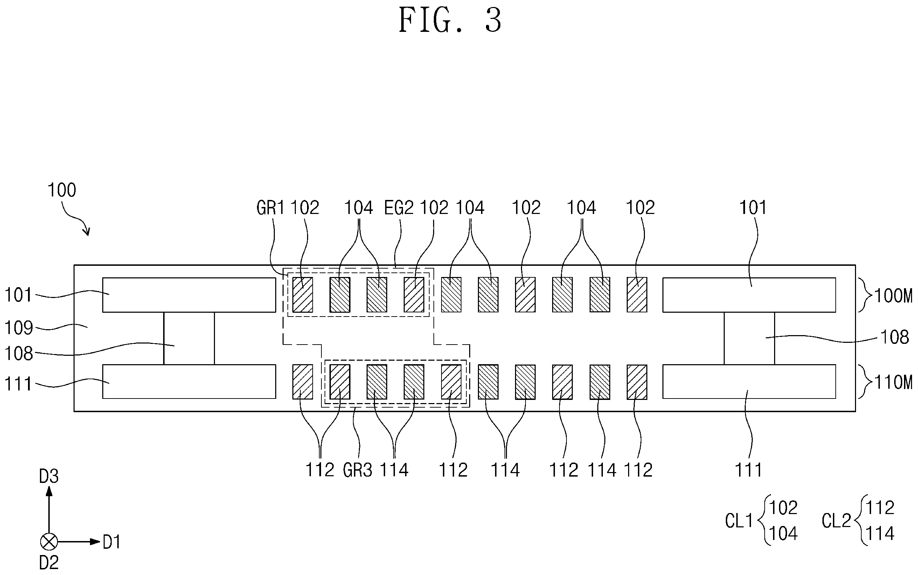

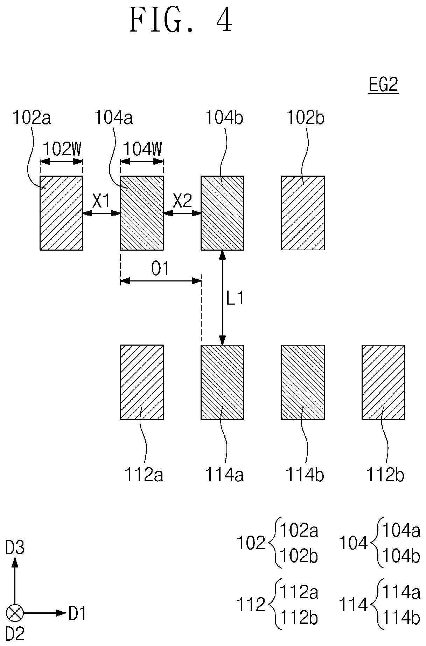

FIG. 3 is a sectional view illustrating a portion of a semiconductor package according to an example embodiment of the inventive concept. FIG. 4 is an enlarged view illustrating a portion 'EG2' of FIG. 3. For the sake of brevity, an element described with reference to FIGS. 1 and 2 may be identified by the same reference number, without repeating an overlapping description thereof.

Referring to FIGS. 3 and 4, the first interconnection layer 100M may include the first conductive lines CL1 arranged along the first arrangement pattern GR1 and the second conductive lines CL2 arranged along a third arrangement pattern GR3. The third arrangement pattern GR3 may have the same shape as the first arrangement pattern GR1 and may be offset from the first arrangement pattern GR1. The first arrangement pattern GR1 may include the first ground line 102, the first signal line 104, the first signal line 104, and the first ground line 102, which are repeatedly arranged in the first direction D1. The second conductive lines CL2 may include two second ground lines 112 and two second signal lines 114 interposed therebetween. The third arrangement pattern GR3 may include the second ground line 112, the second signal line 114, the second signal line 114, and the second ground line 112, which are repeatedly arranged in the first direction D1. The second conductive lines CL2, which are closest to the second pads 111, respectively, may be the second ground lines 112.

In detail, the second signal lines 114 may include two second signal lines 114a and 114b, which are adjacent to each other in the first direction D1, may be offset from the first signal lines 104a and 104b, which are adjacent to each other in the first direction D1, in the first direction D1. In more detail, the second signal lines 114a and 114b may be offset from the first signal lines 104a and 104b, respectively, by an offset distance O1 that is equal to a sum of the second distance X2 between the first signal lines 104a and 104b and the second width 104W of the first signal line 104a.

One (e.g., the first signal line 104b) of the first signal lines 104a and 104b may be adjacent to the other (e.g., the second signal line 114a) of the second signal lines 114a and 114b in the third direction D3. The other (e.g., the first signal line 104a) of the first signal lines 104a and 104b may be adjacent to one (e.g., the second ground line 112b) of the second ground lines 112a and 112b in the third direction D3.

According to an embodiment of the inventive concept, the first interconnection layer 100M may include the first conductive lines CL1, in which two first signal lines 104 are disposed between the first ground lines 102 along the first arrangement pattern GR1, and which are repeatedly arranged in the first direction D1. In the case where the first conductive lines CL1 are arranged along the first arrangement pattern GR1, it may be possible to increase the number of signal lines per unit area and increase the number of routing signals, compared to the case where a single first signal line 104 is disposed between the first ground lines 102 and they are arranged in the first direction D1. The first and second interconnection layers 100M and 110M, which are adjacent to each other, may include the second conductive lines CL2 that are repeatedly arranged along the second arrangement pattern GR2, which is different from the first arrangement pattern GR1 (see FIG. 1) or the third arrangement pattern GR3, which is the same as the first arrangement pattern GR1 but is offset from the first arrangement pattern GR1 in the first direction D1 (see FIG. 3). In the second and third arrangement patterns GR2 and GR3, the arrangement of the second signal lines 114 may be adjusted in such a way that two first signal lines 104, which are adjacent to each other in the first direction D1, and two second signal lines 114, which are adjacent to each other in the third direction D3, are not present. The arrangement of the second arrangement pattern GR2 may be adjusted to include the second ground line 112, which is adjacent to one of the two first signal lines 104 in the third direction D3. As a result, it may be possible to prevent the signal crosstalk phenomenon between the first and second interconnection layers 100M and 110M.

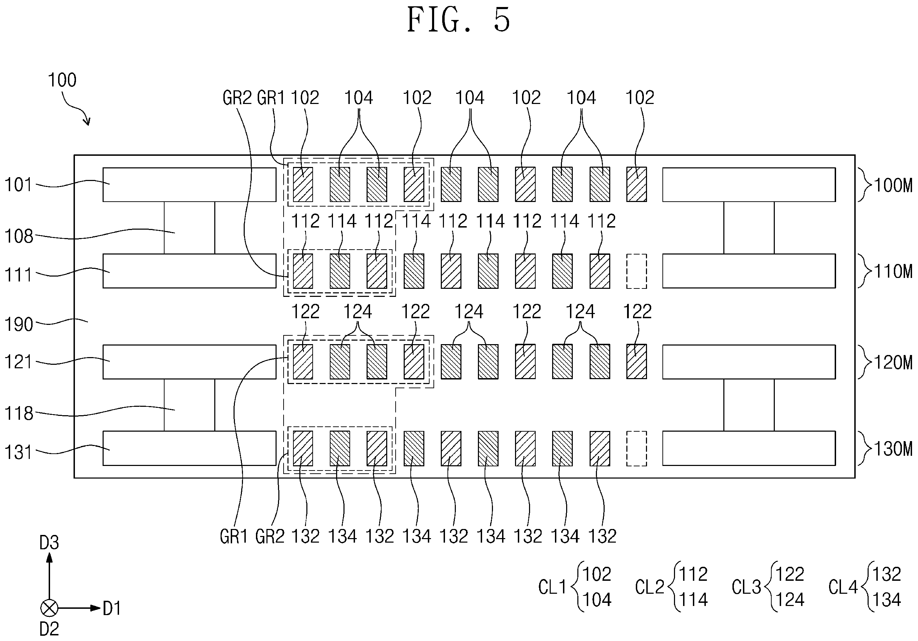

FIG. 5 is a sectional view illustrating a portion of a semiconductor package according to an example embodiment of the inventive concept. For the sake of brevity, an element described with reference to FIG. 1 may be identified by the same reference number, without repeating an overlapping description thereof.

Referring to FIGS. 1 and 5, the wiring substrate 100 may further include a third interconnection layer 120M and a fourth interconnection layer 130M. The third and fourth interconnection layers 120M and 130M may be sequentially disposed on the second interconnection layer 110M. The third interconnection layer 120M may include third pads 121, which are spaced apart from each other in the first direction D1, and third conductive lines CL3 interposed therebetween. The fourth interconnection layer 130M may include fourth pads 131, which are spaced apart from each other in the first direction D1, and fourth conductive lines CL4, which are interposed between the fourth pads 131. Vias 118 may be interposed between the third pads 121 and the fourth pads 131. The third pads 121 and the fourth pads 131 may be electrically connected to each other through the vias 108.

The third conductive lines CL3 may include third ground lines 122 and third signal lines 124 which are disposed in the same manner as the first ground lines 102 and the first signal lines 104. The third conductive lines CL3 may include the third signal lines 124, which are interposed between the third ground lines 122 that are adjacent to each other in the first direction D1. The third conductive lines CL3 may include the third ground line 122, the third signal line 124, the third signal line 124, and the third ground line 122, which are arranged along the first arrangement pattern GR1. The fourth conductive lines CL4 may include fourth ground lines 132 and fourth signal lines 134 which are disposed in the same manner as the second ground lines 112 and the second signal lines 114. The fourth conductive lines CL4 may include the fourth ground lines 132, which are spaced apart from each other in the first direction D1, and the fourth signal line 134, which is interposed therebetween. The fourth conductive lines CL4 may include the fourth ground line 132, the fourth signal line 134, and the fourth ground line 132, which are arranged along the second arrangement pattern GR2.

The relationship between the second conductive lines CL2 and the first and third conductive lines CL1 and CL3 may be substantially the same as described with reference to FIGS. 1 and 2. The relationship between the fourth and third conductive lines CL4 and CL3 may be substantially the same as described with reference to FIGS. 1 and 2. The third interconnection layer 120M may correspond to the first interconnection layer 100M, and the fourth interconnection layer 130M may correspond to the second interconnection layer 110M. For example, the wiring substrate 100 may include a plurality of interconnection layers, in which the first and second interconnection layers 100M and 110M are repeatedly stacked in the third direction D3.

In an embodiment, the wiring substrate 100 may further include a fifth interconnection layer and a sixth interconnection layer, which are sequentially disposed on the fourth interconnection layer 130M. The fifth interconnection layer may correspond to the first interconnection layer 100M, and the sixth interconnection layer may correspond to the second interconnection layer 110M. For example, the wiring substrate 100 may include a plurality of interconnection layers, in which the first and second interconnection layers 100M and 110M are repeatedly stacked in the third direction D3, and the stacking number may be adjusted, as appropriate.

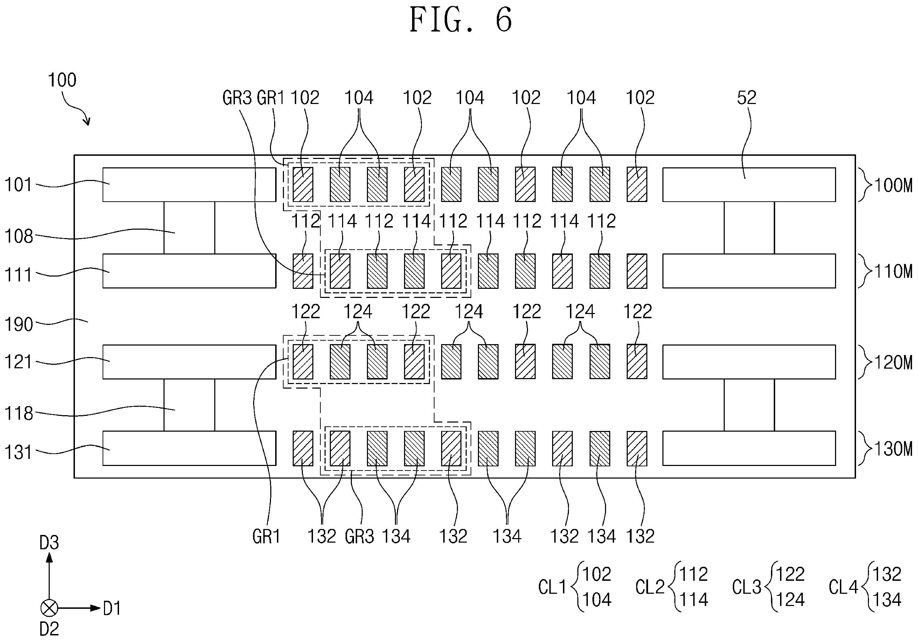

FIG. 6 is a sectional view illustrating a portion of a semiconductor package according to an example embodiment of the inventive concept. For the sake of brevity, an element described with reference to FIG. 3 may be identified by the same reference number, without repeating an overlapping description thereof.

Referring to FIGS. 3 and 6, the wiring substrate 100 may further include a third interconnection layer 120M and a fourth interconnection layer 130M. The third and fourth interconnection layers 120M and 130M may be sequentially disposed on the second interconnection layer 110M. The first conductive lines CL1 may be arranged along the first arrangement pattern GR1, and the second conductive lines CL2 may be arranged along the second arrangement pattern GR2.

The third conductive lines CL3 may include the third ground line 122, the third signal line 124, the third signal line 124, and the third ground line 122, which are arranged along the first arrangement pattern GR1. The fourth conductive lines CL4 may include the fourth ground line 132, the fourth signal line 134, the fourth signal line 134, and the fourth ground line 132, which are arranged along the third arrangement pattern GR3.

The relationship between the second conductive lines CL2 and the first and third conductive lines CL1 and CL3 may be substantially the same as described with reference to FIGS. 3 and 4. The relationship between the fourth and third conductive lines CL4 and CL3 may be substantially the same as described with reference to FIGS. 3 and 4. The third interconnection layer 120M may correspond to the first interconnection layer 100M, and the fourth interconnection layer 130M may correspond to the second interconnection layer 110M. In an embodiment, the wiring substrate 100 may further include a fifth interconnection layer and a sixth interconnection layer, which are sequentially disposed on the fourth interconnection layer 130M. The fifth interconnection layer may correspond to the first interconnection layer 100M, and the sixth interconnection layer may correspond to the second interconnection layer 110M. For example, the wiring substrate 100 may include a plurality of interconnection layers, in which the first and second interconnection layers 100M and 110M are repeatedly stacked in the third direction D3.

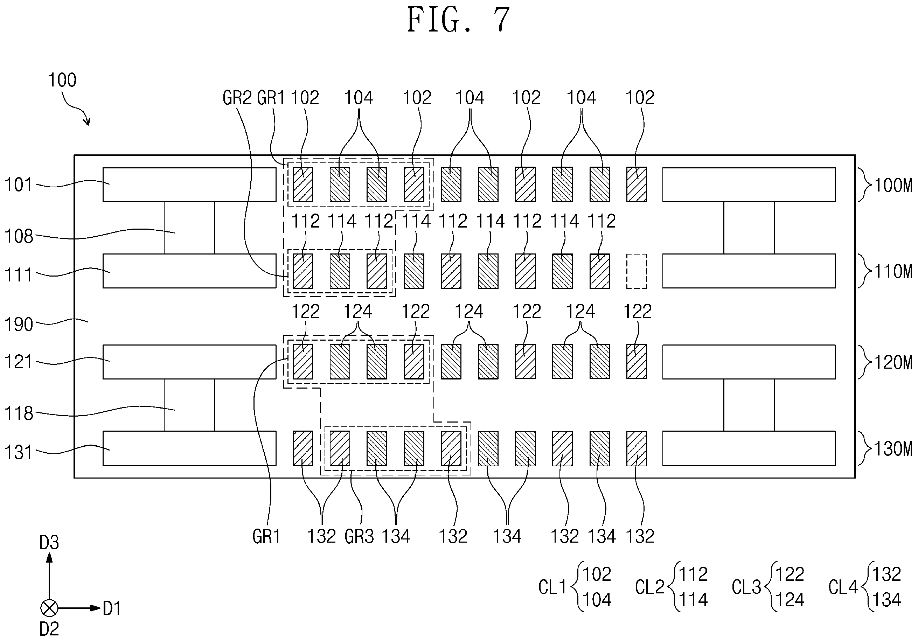

FIG. 7 is a sectional view illustrating a portion of a semiconductor package according to an example embodiment of the inventive concept. For the sake of brevity, an element described with reference to FIGS. 1 and 2 may be identified by the same reference number, without repeating an overlapping description thereof.

Referring to FIG. 7, the wiring substrate 100 may include the first, second, third, and fourth interconnection layers 100M, 110M, 120M, and 130M, which are sequentially arranged in the third direction D3. The first interconnection layer 100M may include the first conductive lines CL1, the second interconnection layer 110M may include the second conductive lines CL2, the third interconnection layer 120M may include the third conductive lines CL3, and the fourth interconnection layer 130M may include the fourth conductive lines CL4. The first and third conductive lines CL1 and CL3 may be arranged along the first arrangement pattern GR1. The disposition shape of the first conductive lines CL1 and the disposition shape of the third conductive lines CL3 may be substantially the same. The second conductive lines CL2 may be arranged along the second arrangement pattern GR2, and the fourth conductive lines CL4 may be arranged along the third arrangement pattern GR3. The relationship between the second conductive lines CL2 and the first and third conductive lines CL1 and CL3 may be substantially the same as described with reference to FIGS. 1 and 2. The relationship between the fourth and third conductive lines CL4 and CL3 may be substantially the same as described with reference to FIGS. 3 and 4.

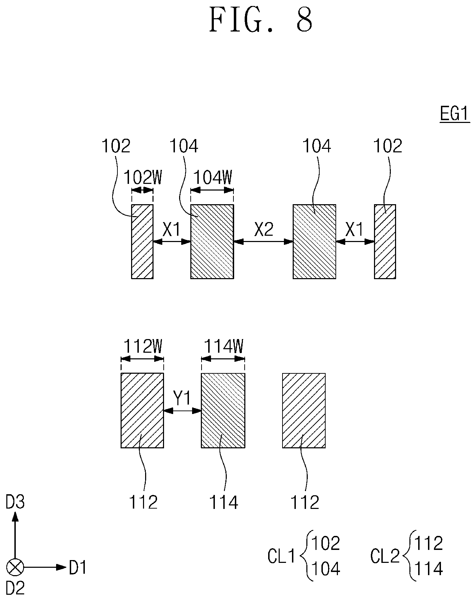

FIG. 8 is an enlarged view corresponding to the portion 'EG1' of FIG. 1. For the sake of brevity, an element described with reference to FIG. 2 may be identified by the same reference number, without repeating an overlapping description thereof.

Referring to FIGS. 1 and 8, the first ground line 102 may have a first width 102W in the first direction D1, the first signal line 104 may have a second width 104W in the first direction D1, the second ground line 112 may have a third width 112W in the first direction D1, and the second signal line 114 may have a fourth width 114W in the first direction D1. The first width 102W may be smaller than the second width 104W. A first distance X1 between the first ground line 102 and the first signal line 104, which are adjacent to each other in the first direction D1, may be smaller than a second distance X2 between two adjacent ones of the first signal lines 104 in the first direction D1.

In an embodiment, the first width 102W may be smaller than the third and fourth widths 112W and 114W. In an embodiment, a third distance Y1 between the second ground line 112 and the second signal line 114, which are adjacent to each other in the first direction D1, may be substantially equal to the first distance X1 and may be smaller than the second distance X2.

According to an embodiment of the inventive concept, by increasing the second distance X2 between the first signal lines 104 of the first interconnection layer 100M, which include more signal lines than the second interconnection layer 110M, it may be possible to reduce a signal interference effect. By decreasing the width 102W of each of the first ground lines 102 instead of increasing the second distance X2 between the first signal lines 104, it may be possible to suppress the signal interference effect without reducing the number of the first signal lines 104 within a given area.

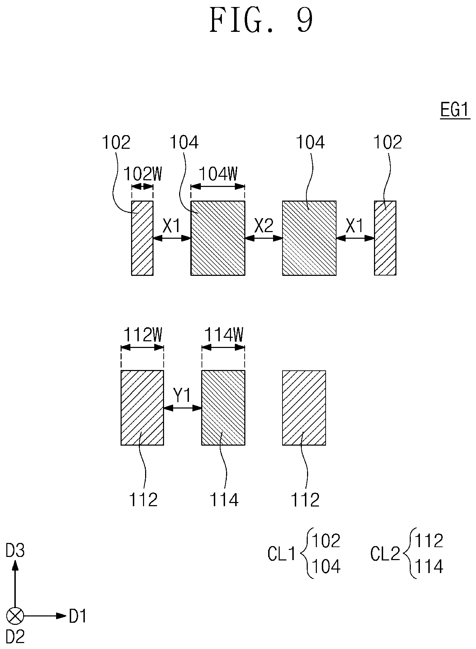

FIG. 9 is an enlarged view corresponding to the portion 'EG1' of FIG. 1.

For the sake of brevity, an element described with reference to FIG. 2 may be identified by the same reference number, without repeating an overlapping description thereof. Referring to FIGS. 1 and 9, the first distance X1 between the first ground line 102 and the first signal line 104, which are adjacent to each other in the first direction D1, may be substantially equal to the second distance X2 between two adjacent ones of the first signal lines 104 in the first direction D1. The first width 102W may be smaller than the second width 104W.

In an embodiment, the third distance Y1 between the second ground line 112 and the second signal line 114, which are adjacent to each other in the first direction D1, may be substantially equal to the first and second distances X1 and X2. In an embodiment, the first width 102W may be smaller than the third and fourth widths 112W and 114W. In an embodiment, the second width 104W may be greater than the third and fourth widths 112W and 114W.

According to an embodiment of the inventive concept, by increasing the width 104W of each of the first signal lines 104 of the first interconnection layer 100M, which includes more signal lines than the second interconnection layer 110M, it may be possible to reduce an inductance property and thereby to improve the quality of signals. By decreasing the width 102W of each of the first ground lines 102 instead of increasing the width 104W of each of the first signal lines 104, it may be possible to improve the signal quality without reducing the number of the first signal lines 104 within a given area.

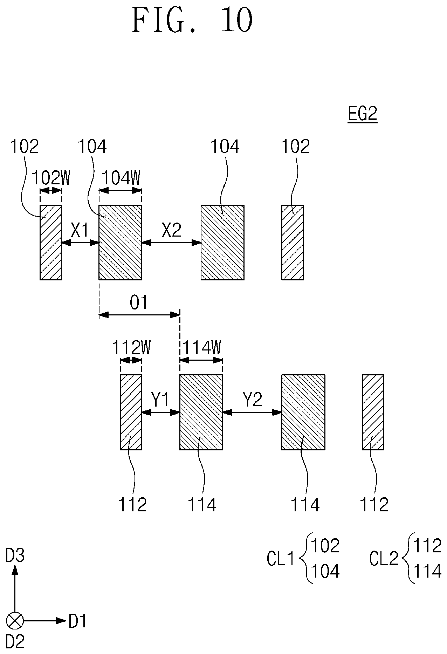

FIG. 10 is an enlarged view corresponding to the portion 'EG2' of FIG. 3. For the sake of brevity, an element described with reference to FIG. 4 may be identified by the same reference number, without repeating an overlapping description thereof.

Referring to FIGS. 3 and 10, the first width 102W may be smaller than the second width 104W. The third width 112W may be smaller than the fourth width 114W. The first distance X1 may be smaller than the second distance X2. The third distance Y1 may be smaller than a fourth distance Y2 between adjacent ones of the second signal lines 114 in the first direction D1.

In an embodiment, the first distance X1 may be smaller than the fourth distance Y2. In an embodiment, the third distance Y1 may be smaller than the second distance X2.

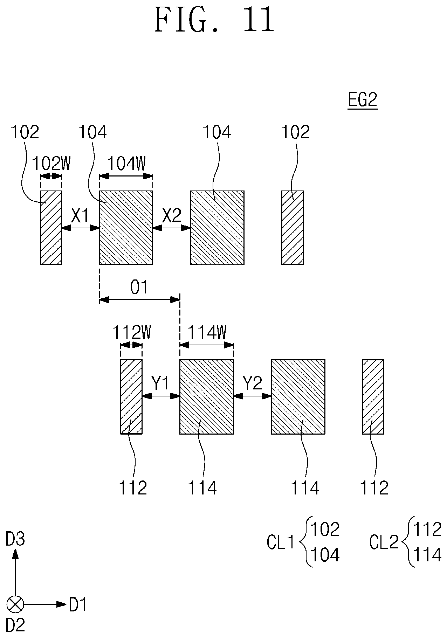

FIG. 11 is an enlarged view corresponding to the portion 'EG2' of FIG. 3. For the sake of brevity, an element described with reference to FIG. 4 may be identified by the same reference number, without repeating an overlapping description thereof.

Referring to FIGS. 3 and 11, the first width 102W may be smaller than the second width 104W.

The third width 112W may be smaller than the fourth width 114W. The first distance X1 may be substantially equal to the second distance X2. The third distance Y1 may be substantially equal to the fourth distance Y2. In an embodiment, the first to fourth distances X1, X2, Y1, and Y2 may be substantially equal to each other. In an embodiment, the first width 102W may be smaller than the fourth width 114W. In an embodiment, the third width 112W may be smaller than the second width 104W.

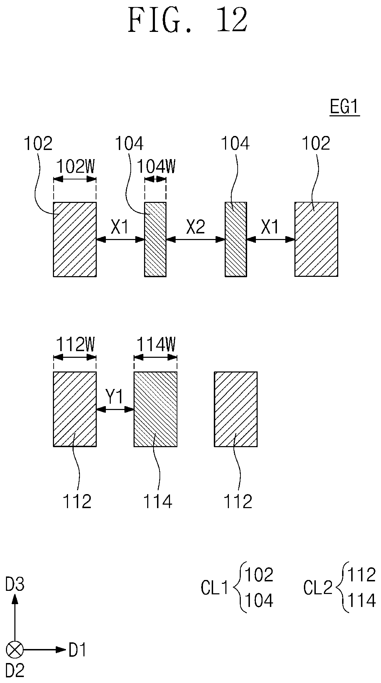

FIG. 12 is an enlarged view corresponding to the portion 'EG1' of FIG. 1. For the sake of brevity, an element described with reference to FIG. 2 may be identified by the same reference number, without repeating an overlapping description thereof. Referring to FIGS. 1 and 12, the second width 104W of the first signal line 104 may be smaller than the first width 102W of the first ground line 102. The first distance X1 between the first ground line 102 and the first signal line 104, which are adjacent to each other in the first direction D1, may be smaller than the second distance X2 between two adjacent ones of the first signal lines 104 in the first direction D1. In an embodiment, the fourth width 114W of the second signal line 114 may be larger than or substantially equal to the second width 104W. In an embodiment, the third distance Y1 between the second ground line 112 and the second signal line 114, which are adjacent to each other in the first direction D1, may be substantially equal to or smaller than the first distance X1. In an embodiment, the third distance Y1 may be smaller than the second distance X2.

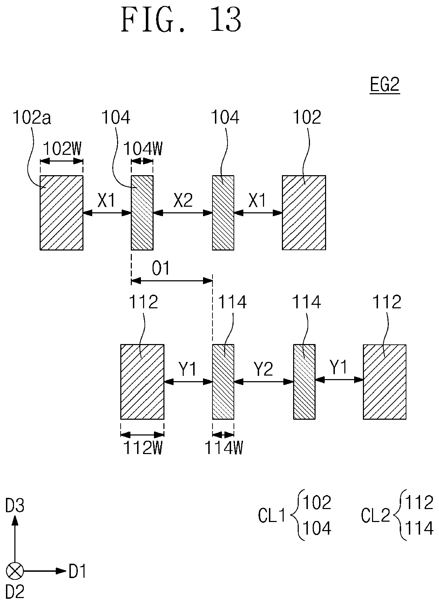

FIG. 13 is an enlarged view corresponding to the portion 'EG2' of FIG. 3. For the sake of brevity, an element described with reference to FIG. 4 may be identified by the same reference number, without repeating an overlapping description thereof. Referring to FIGS. 3 and 13, the second width 104W may be smaller than the first width 102W. The first distance X1 may be smaller than the second distance X2. The fourth width 114W may be smaller than the third width 112W. The fourth distance Y2 may be smaller than the third distance Y1. In an embodiment, the first distance X1 may be substantially equal to the third distance Y1, and the second distance X2 may be substantially equal to the fourth distance Y2.

According to an embodiment of the inventive concept, a first signal line may be provided to have a width smaller than that of a first ground line, and a distance between the first signal lines may be larger than a distance between the first signal line and the first ground line, which are adjacent to each other. Since the ground line is provided to have a large width, the resistance and the power consumption may be reduced, and since the distance between the first signal lines is large, the signal interference issue may be mitigated. In addition, by reducing the width of the first signal lines, it may be possible to maintain the number of the first signal lines within a given area, even if the distance between the first signal lines is increased.

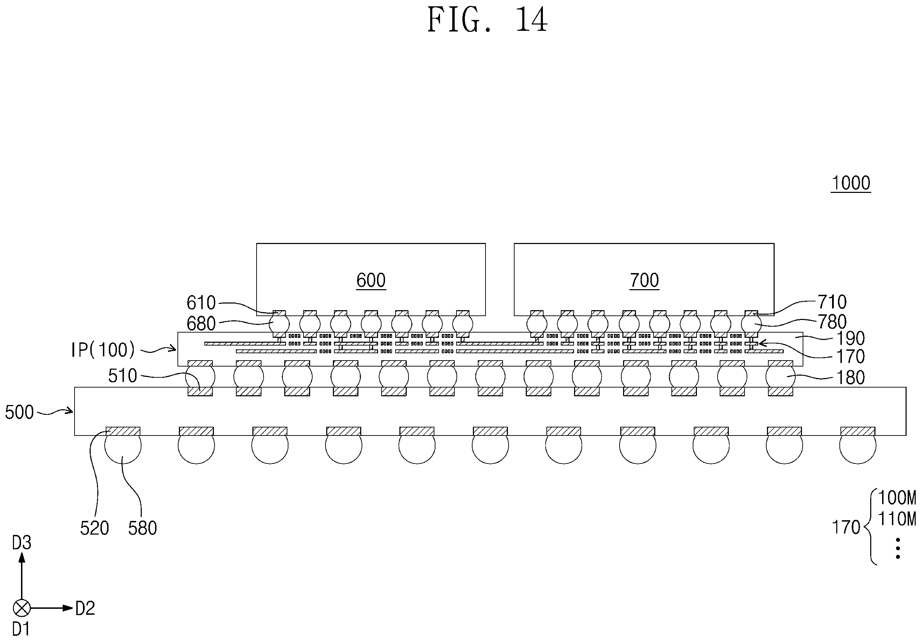

FIG. 14 is a diagram illustrating a semiconductor package according to an example embodiment of the inventive concept.

Referring to FIG. 14, a semiconductor package 1000 may include a package substrate 500, an interposer IP, a first semiconductor chip 600, and a second semiconductor chip 700.

The package substrate 500 may be, for example, a printed circuit board (PCB). The package substrate 500 may include upper substrate pads 510 and lower substrate pads 520. The upper substrate pads 510 may be disposed on a top surface of the package substrate 500, and the lower substrate pads 520 may be disposed on a bottom surface of the package substrate 500. Outer connection terminals 580 may be disposed on the lower substrate pad 520. The outer connection terminals 580 may include, for example, a soldering material.

The interposer IP may be disposed on the package substrate 500. The interposer IP may be, for example, a redistribution interposer. The redistribution interposer may be a substrate including a photoimageable insulating material (e.g., polyimide) and metal lines. The metal lines may include a seed pattern and a conductive pattern on the seed pattern. The metal lines may include via plugs and lines. The interposer IP may correspond to the wiring substrate 100 described with reference to FIGS. 1 to 13. The interposer IP may include an insulating layer 190 and interconnection layers 170 on the insulating layer 190. Inner connection terminals 180 may be interposed between the interposer IP and the package substrate 500. The inner connection terminals 180 may be in direct contact with pads on the lower surface of the insulating layer 190 and the upper substrate pads 510. The inner connection terminals 180 may include, for example, a soldering material.

The first and second semiconductor chips 600 and 700 may be disposed on the interposer IP. The first and second semiconductor chips 600 and 700 may be spaced apart from each other in the second direction D2. The first and second semiconductor chips 600 and 700 may either be of the same kind or different kinds. For example, the first semiconductor chip 600 may be a memory chip (e.g., DRAM chip), and the second semiconductor chip 700 may be a logic chip (e.g., ASIC). The first semiconductor chip 600 may include first chip pads 610, and a first connection terminal 680 may be interposed between the first semiconductor chip 600 and the interposer IP. The second semiconductor chip 700 may include a second chip pad 710, and a second connection terminal 780 may be interposed between the second semiconductor chip 700 and the interposer IP. The first semiconductor chip 600 may be electrically connected to the interposer IP through the first connection terminal 680, and the second semiconductor chip 700 may be electrically connected to the interposer IP through the second connection terminal 780. The interposer IP may include a plurality of interconnection layers 170, as described above. The interconnection layers 170 may include the first and second interconnection layers 100M and 110M, which are alternately stacked in the third direction D3. The first and second semiconductor chips 600 and 700 may be electrically connected to each other through the first and second conductive lines CL1 and CL2 of the first and second interconnection layers 100M and 110M, which extend lengthwise in the second direction D2.

According to an embodiment of the inventive concept, since the interposer IP includes the wiring substrate 100 described with reference to FIGS. 1 to 13, it may be possible to improve the quality of signals that are transmitted in the signal transmission process between the first and second semiconductor chips 600 and 700. In addition, by using the wiring substrate 100, it may be possible to increase the density of the signal lines within a given area and thereby to transmit more signals, even without increasing the thickness of the wiring substrate 100 is not increased.

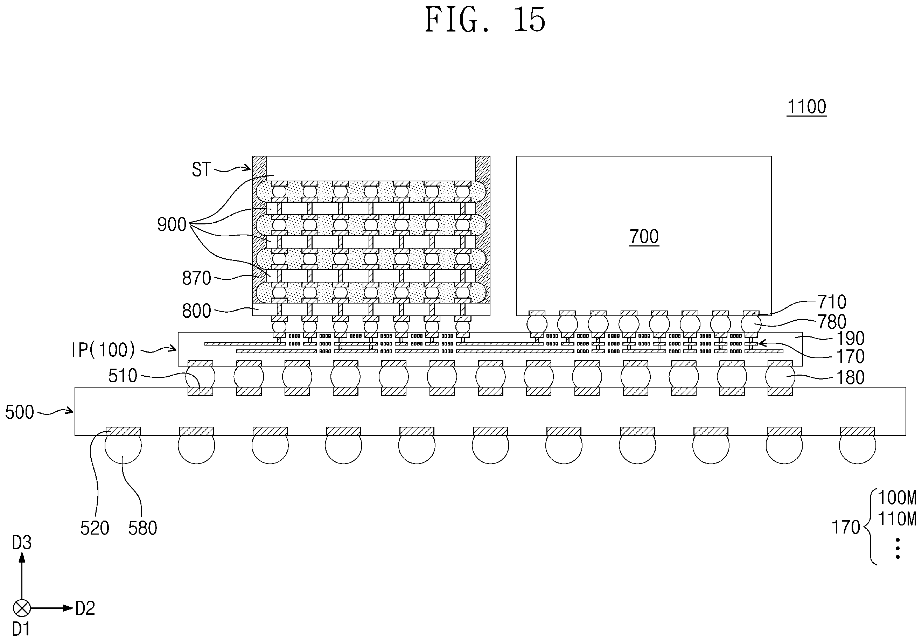

FIG. 15 is a diagram illustrating a semiconductor package according to an example embodiment of the inventive concept. Except for features to be described below, the semiconductor package according to the present embodiment may have substantially the same features as described with reference to FIG. 14, and thus, an overlapping description thereof may be omitted.

Referring to FIG. 15, a semiconductor package 1100 may include a chip stack ST and the second semiconductor chip 700. The chip stack ST may be spaced apart from the second semiconductor chip 700 in the second direction D2. The chip stack ST and the second semiconductor chip 700 may be disposed on the interposer IP.

The chip stack ST may include a third semiconductor chip 800 and a plurality of fourth semiconductor chips 900. The third semiconductor chip 800 may be, for example, a buffer chip. The fourth semiconductor chip 900 may be, for example, a memory chip (e.g., DRAM chip). The second semiconductor chip 700 may be, for example, a logic chip (e.g., ASIC). Each of the third and fourth semiconductor chips 800 and 900 may include a semiconductor substrate and penetration vias penetrating the same. The chip stack ST may be, for example, a high bandwidth memory (HBM). Micro-bumps may be disposed between the third and fourth semiconductor chips 800 and 900 and between the fourth semiconductor chips 900. An adhesive layer may be interposed between the third and fourth semiconductor chips 800 and 900 and between the fourth semiconductor chips 900 to fill a space between the micro-bumps. A mold layer 870 may cover a top surface of the third semiconductor chip 800, side surfaces of the fourth semiconductor chips 900, and side surfaces of the adhesive layers. The mold layer 870 may be formed of or include a polymer insulating material (e.g., an epoxy molding compound).

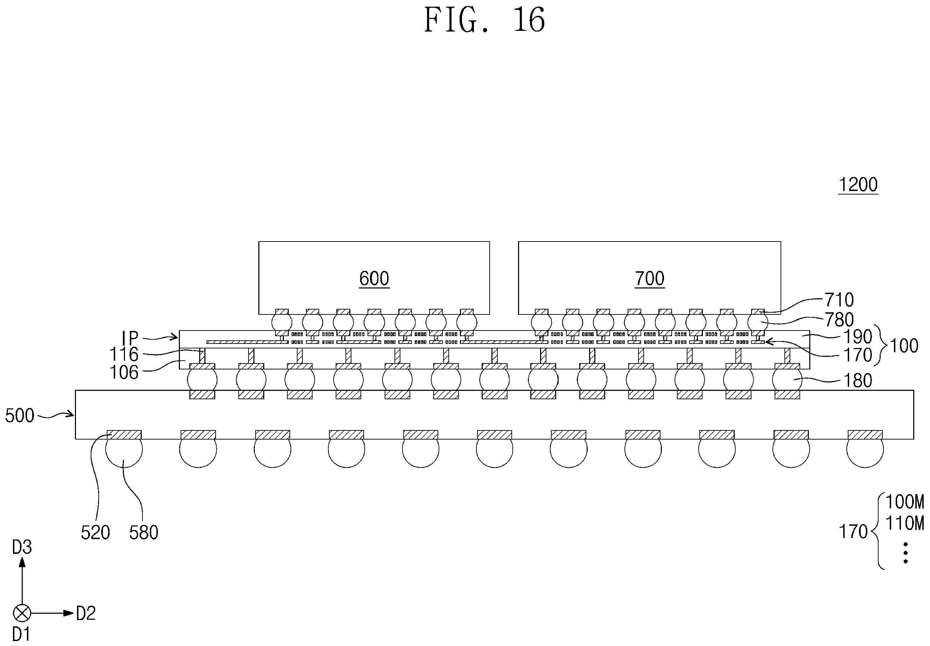

FIG. 16 is a sectional view illustrating a semiconductor package according to an example embodiment of the inventive concept. Except for features to be described below, the semiconductor package according to the present embodiment may have substantially the same features as described with reference to FIG. 14, and thus, an overlapping description thereof may be omitted.

Referring to FIG. 16, a semiconductor package 1200 may include a semiconductor substrate 106, a penetration via 116 penetrating the semiconductor substrate 106, and the interposer IP including the wiring substrate 100. The interposer IP may be, for example, a silicon interposer. The semiconductor substrate 106 may be, for example, a silicon substrate, and the penetration via 116 may be, for example, a through silicon via (TSV). The wiring substrate 100 may be configured to have substantially the same features as the wiring substrate 100 described with reference to FIGS. 1 to 13. The wiring substrate 100 may be electrically connected to the package substrate 500 through the penetration via 116.

According to an embodiment of the inventive concept, a first interconnection layer and a second interconnection layer, which are adjacent to each other, may be provided. The first and second interconnection layers may be alternately stacked. The first interconnection layer may include a first ground line, a first signal line, a first signal line, and a first ground line, which are repeatedly arranged. In the second interconnection layer, by adjusting the disposition of a signal line in a second interconnection layer, it may be possible to reduce signal interference between the first and second interconnection layers and improve the quality of signals. Furthermore, in the first interconnection layer, a plurality of signal lines may be disposed between the ground lines, and in this case, it may be possible to increase a density of the signal lines within a given area.

## Claims

1. A semiconductor package (1000), comprising:
a wiring substrate (100) including a plurality of interconnection layers (170),
wherein the plurality of interconnection layers (170) comprise:
a first interconnection layer (100M); and
a second interconnection layer (110M) on the first interconnection layer (100M),
wherein the first interconnection layer (100M) comprises first conductive lines (CL1), which include two first ground lines (102) spaced apart from each other in a first direction (D1) and two first signal lines (104) interposed therebetween, and which extend lengthwise in a second direction (D2) perpendicular to the first direction (D1),
wherein the second interconnection layer (110M) comprises second conductive lines (CL2) including a second signal line A (114), which is adjacent to one of the first signal lines (104) in a third direction (D3) perpendicular to the first and second directions (D1, D2), and a second ground line A (112), which is adjacent to another of the first signal lines (104) in the third direction (D3), and
wherein the second conductive lines (CL2) extend lengthwise in the second direction (D2),
wherein the first interconnection layer (100M) further comprises first pads (101), which are spaced apart from each other in the first direction (D1) with the first conductive lines (CL1) disposed therebetween,
wherein the second interconnection layer (110M) further comprises second pads (111), which are spaced apart from each other in the first direction (D1) with the second conductive lines (CL2) disposed therebetween,
wherein each of the first and second conductive lines (CL1, CL2) extends lengthwise in the second direction (D2),
wherein the first conductive lines (CL1) comprise first ground lines (102) and first signal lines (104) arranged along a first arrangement pattern (GR1),
wherein the second conductive lines (CL2) comprise second ground lines (112) and second signal lines (114) arranged along a second arrangement pattern (GR2), and
wherein the first arrangement pattern (GR1) is a pattern in which the first ground line (102), the first signal line (104), the first signal line (104), and the first ground line (102) are repeatedly arranged in the first direction (D1).

2. The semiconductor package (1000) of claim 1, wherein the two first ground lines (102) and the two first signal lines (104) are adjacently arranged in the order of the first ground line (102), the first signal line (104), the first signal line (104), and the first ground line (102) in the first direction (D1).

3. The semiconductor package (1000) of claim 1 or claim 2,
wherein the second conductive lines (CL2) comprise two second ground lines (112) including the second ground line A (112) and a second ground line B (112) spaced apart from each other in the first direction (D1), and the second signal line A (114) interposed therebetween, and
wherein the second signal line A (114) is adjacent to the two second ground lines (112).

4. The semiconductor package (1000) of claim 1 or claim 2,
wherein the second conductive lines (CL2) comprise two second ground lines (112), including the second ground line A (112) and a second ground line B (112), and two second signal lines (114), including the second signal line A (114) and a second signal line B (114), interposed therebetween in the first direction (D1), and
wherein the two second signal lines (114) are adjacent to each other.

5. The semiconductor package (1000) of any of claims 1-3,
wherein the first conductive lines (CL1) are arranged along a first arrangement pattern (GR1),
wherein the second conductive lines (CL2) are arranged along a second arrangement pattern (GR2), and
wherein the first and second arrangement patterns (GR1, GR2) are different from each other.

6. The semiconductor package (1000) of any of claims 1, 2 or 4,
wherein the first conductive lines (CL1) are arranged along a first arrangement pattern (GR1),
wherein the second conductive lines (CL2) are arranged along a second arrangement pattern (GR3),
wherein the first and second arrangement patterns (GR1, GR3) are the same as each other, and
wherein the second conductive lines (CL2) comprise an arrangement pattern (GR3) offset from the first conductive lines (CL1) in the first direction (D1).

7. The semiconductor package (1000) of claim 6, wherein the second conductive lines (CL2) are offset from the first conductive lines (CL1) by a distance (O1) that is given as a sum of a width (104W) of the first signal line (104) in the first direction (D1) and a distance (X2) between the two first signal lines (104) in the first direction (D1).

8. The semiconductor package (1000) of any preceding claim, wherein a distance (L1) between the first and second interconnection layers (100M, 110M) in the third direction (D3) is larger than a distance (X2) between the first signal lines (104) in the first direction (D1).

9. The semiconductor package (1000) of any preceding claim, wherein a distance (X1) between a first ground line (102) of the two first ground lines (102) and a first signal line (104) of the two first signal lines (104), which are adjacent to each other, is equal to a distance (X2) between the two first signal lines (104), which are adjacent to each other.

10. The semiconductor package (1000) of any of claims 1-8, wherein a distance (X1) between a first ground line (102) of the two first ground lines (102) and a first signal line (104) of the two first signal lines (104), which are adjacent to each other, is smaller than a distance (X2) between the two first signal lines (104), which are adjacent to each other.

11. The semiconductor package (1000) of claim 10, wherein a width (102W) of the first ground line (102) in the first direction (D1) is smaller than a width (104W) of the first signal line (104) in the first direction (D1).

12. The semiconductor package (1000) of claim 10, wherein a width (102W) of the first ground line (102) in the first direction (D1) is larger than a width (104W) of the first signal line (104) in the first direction (D1).

13. The semiconductor package (1000) of any preceding claim,
wherein the first interconnection layer (100M) further comprises first pads (101), which are spaced apart from each other in the first direction (D1) with the first conductive lines (CL1) interposed therebetween,
wherein the second interconnection layer (110M) further comprises second pads (111), which are spaced apart from each other in the first direction (D1) with the second conductive lines (CL2) interposed therebetween, and
wherein the semiconductor package (1000) further comprises vias (108) directly connecting the first pads (101) to the second pads (111).

14. The semiconductor package (1000) of claim 1,
wherein the second arrangement pattern (GR2) is different from the first arrangement pattern (GR1), and
wherein the second arrangement pattern (GR2) is a pattern in which the second ground line (112), the second signal line (114), and the second ground line (112) are repeatedly arranged in the first direction (D1).

## Patentansprüche

1. Halbleiter-Package (1000), umfassend:
ein Verdrahtungssubstrat (100), das eine Vielzahl von Verbindungsschichten (170) beinhaltet,
wobei die Vielzahl von Verbindungsschichten (170) Folgendes umfasst:
eine erste Verbindungsschicht (100M); und
eine zweite Verbindungsschicht (110M) auf der ersten Verbindungsschicht (100M),
wobei die erste Verbindungsschicht (100M) erste Leiterbahnen (CL1) umfasst, die zwei erste Masseleitungen (102) beinhalten, die in einer ersten Richtung (D1) voneinander beabstandet sind, und zwei erste Signalleitungen (104), die dazwischen angeordnet sind und die sich in längs in einer zweiten Richtung (D2) senkrecht zur ersten Richtung (D1) erstrecken,
wobei die zweite Verbindungsschicht (110M) zweite Leiterbahnen (CL2) umfasst, die eine zweite Signalleitung A (114) beinhalten, die in einer dritten Richtung (D3), senkrecht zur ersten und zweiten Richtung (D1, D2) an eine der ersten Signalleitungen (104) angrenzt, und eine zweite Masseleitung A (112), die in der dritten Richtung (D3) an eine andere der ersten Signalleitungen (104) angrenzt, und
wobei sich die zweiten Leiterbahnen (CL2) längs in der zweiten Richtung (D2) erstrecken,
wobei die erste Verbindungsschicht (100M) weiter erste Kontaktflächen (101) umfasst, die in der ersten Richtung (D1) voneinander beabstandet sind, wobei die ersten Leiterbahnen (CL1) dazwischen angeordnet sind,
wobei die zweite Verbindungsschicht (110M) weiter zweite Kontaktflächen (111) umfasst, die in der ersten Richtung (D1) voneinander beabstandet sind, wobei die zweiten Leiterbahnen (CL2) dazwischen angeordnet sind,
wobei sich jede der ersten und der zweiten Leiterbahnen (CL1, CL2) längs in der zweiten Richtung (D2) erstreckt,
wobei die ersten Leiterbahnen (CL1) erste Masseleitungen (102) und erste Signalleitungen (104) umfassen, die entlang eines ersten Anordnungsmusters (GR1) angeordnet sind,
wobei die zweiten Leiterbahnen (CL2) zweite Masseleitungen (112) und zweite Signalleitungen (114) umfassen, die entlang eines zweiten Anordnungsmusters (GR2) angeordnet sind, und
wobei das erste Anordnungsmuster (GR1) ein Muster ist, in dem die erste Masseleitung (102), die erste Signalleitung (104), die erste Signalleitung (104) und die erste Masseleitung (102) wiederholt in der ersten Richtung (D1) angeordnet sind.

2. Halbleiter-Package (1000) nach Anspruch 1, wobei die beiden ersten Masseleitungen (102) und die beiden ersten Signalleitungen (104) in der Reihenfolge erste Masseleitung (102), erste Signalleitung (104), erste Signalleitung (104) und erste Masseleitung (102) in der ersten Richtung (D1) angrenzend angeordnet sind.

3. Halbleiter-Package (1000) nach Anspruch 1 oder Anspruch 2,
wobei die zweiten Leiterbahnen (CL2) zwei zweite Masseleitungen (112) umfassen, die die zweite Masseleitung A (112) und eine zweite Masseleitung B (112) beinhalten, die in der ersten Richtung (D1) voneinander beabstandet sind, und die zweite Signalleitung A (114) dazwischen angeordnet ist, und
wobei die zweite Signalleitung A (114) an die beiden zweiten Masseleitungen (112) angrenzt.

4. Halbleiter-Package (1000) nach Anspruch 1 oder Anspruch 2,
wobei die zweiten Leiterbahnen (CL2) zwei zweite Masseleitungen (112), die die zweite Masseleitung A (112) und eine zweite Masseleitung B (112) beinhalten, und zwei zweite Signalleitungen (114), die die zweite Signalleitung A (114) und eine zweite Signalleitung B (114) beinhalten, die in der ersten Richtung (D1) dazwischen angeordnet sind, umfassen, und
wobei die beiden zweiten Signalleitungen (114) aneinander angrenzen.

5. Halbleiter-Package (1000) nach einem der Ansprüche 1-3,
wobei die ersten Leiterbahnen (CL1) entlang eines ersten Anordnungsmusters (GR1) angeordnet sind,
wobei die zweiten Leiterbahnen (CL2) entlang eines zweiten Anordnungsmusters (GR2) angeordnet sind, und
wobei sich das erste und das zweite Anordnungsmuster (GR1, GR2) voneinander unterscheiden.

6. Halbleiter-Package (1000) nach einem der Ansprüche 1, 2 oder 4,
wobei die ersten Leiterbahnen (CL1) entlang eines ersten Anordnungsmusters (GR1) angeordnet sind,
wobei die zweiten Leiterbahnen (CL2) entlang eines zweiten Anordnungsmusters (GR3) angeordnet sind, und
wobei das erste und das zweite Anordnungsmuster (GR1, GR3) gleich sind, und
wobei die zweiten Leiterbahnen (CL2) ein Anordnungsmuster (GR3) umfassen, das gegenüber den ersten Leiterbahnen (CL1) in der ersten Richtung (D1) versetzt ist.

7. Halbleiter-Package (1000) nach Anspruch 6, wobei die zweiten Leiterbahnen (CL2) gegenüber den ersten Leiterbahnen (CL1) um einen Abstand (01) versetzt sind, der sich als eine Summe einer Breite (104W) der ersten Signalleitung (104) in der ersten Richtung (D1) und eines Abstands (X2) zwischen den beiden ersten Signalleitungen (104) in der ersten Richtung (D1) ergibt.

8. Halbleiter-Package (1000) nach einem vorstehenden Anspruch, wobei ein Abstand (L1) zwischen den ersten und den zweiten Verbindungsschichten (100M, 110M) in der dritten Richtung (D3) größer ist als ein Abstand (X2) zwischen den ersten Signalleitungen (104) in der ersten Richtung (D1).

9. Halbleiter-Package (1000) nach einem vorstehenden Anspruch, wobei ein Abstand (X1) zwischen einer ersten Masseleitung (102) der beiden ersten Masseleitungen (102) und einer ersten Signalleitung (104) der beiden ersten Signalleitungen (104), die einander angrenzen, gleich einem Abstand (X2) zwischen den beiden ersten Signalleitungen (104) ist, die aneinander angrenzen.

10. Halbleiter-Package (1000) nach einem der Ansprüche 1-8, wobei ein Abstand (X1) zwischen einer ersten Masseleitung (102) der beiden ersten Masseleitungen (102) und einer ersten Signalleitung (104) der beiden ersten Signalleitungen (104), die einander angrenzen, kleiner als ein Abstand (X2) zwischen den beiden ersten Signalleitungen (104) ist, die aneinander angrenzen.

11. Halbleiter-Package (1000) nach Anspruch 10, wobei eine Breite (102W) der ersten Masseleitung (102) in der ersten Richtung (D1) kleiner ist als eine Breite (104W) der ersten Signalleitung (104) in der ersten Richtung (D1).

12. Halbleiter-Package (1000) nach Anspruch 10, wobei eine Breite (102W) der ersten Masseleitung (102) in der ersten Richtung (D1) größer ist als eine Breite (104W) der ersten Signalleitung (104) in der ersten Richtung (D1).

13. Halbleiter-Package (1000) nach einem vorstehenden Anspruch,
wobei die erste Verbindungsschicht (100M) weiter erste Kontaktflächen (101) umfasst, die in der ersten Richtung (D1) voneinander beabstandet sind, wobei die ersten Leiterbahnen (CL1) dazwischen eingeworfen sind,
wobei die zweite Verbindungsschicht (110M) weiter zweite Kontaktflächen (111) umfasst, die in der ersten Richtung (D1) voneinander beabstandet sind, wobei die zweiten Leiterbahnen (CL2) dazwischen eingeworfen sind, und
wobei das Halbleiter-Package (1000) weiter Durchkontaktierungen (108) umfasst, die die ersten Kontaktflächen (101) direkt mit den zweiten Kontaktflächen (111) verbinden.

14. Halbleiter-Package (1000) nach Anspruch 1,
wobei sich das zweite Anordnungsmuster (GR2) vom ersten Anordnungsmuster (GR1) unterscheidet, und
wobei das zweite Anordnungsmuster (GR2) ein Muster ist, bei dem die zweite Masseleitung (112), die zweite Signalleitung (114) und die zweite Masseleitung (112) wiederholt in der ersten Richtung (D1) angeordnet sind.

## Revendications

1. Boîtier de semi-conducteur (1000), comprenant :
un substrat de câblage (100) incluant une pluralité de couches d'interconnexion (170),
dans lequel la pluralité de couches d'interconnexion (170) comprend :
une première couche d'interconnexion (100M); et
une deuxième couche d'interconnexion (110M) sur la première couche d'interconnexion (100M),
dans lequel la première couche d'interconnexion (100M) comprend des premières lignes conductrices (CL1), qui incluent deux premières lignes de masse (102) espacées l'une de l'autre dans une première direction (D1) et deux premières lignes de signal (104) interposées entre elles, et qui s'étendent longitudinalement dans une deuxième direction (D2) perpendiculaire à la première direction (D1),
dans lequel la deuxième couche d'interconnexion (110M) comprend des deuxièmes lignes conductrices (CL2) incluant une deuxième ligne de signal A (114), qui est adjacente à l'une des premières lignes de signal (104) dans une troisième direction (D3) perpendiculaire aux première et deuxième directions (D1, D2), et une deuxième ligne de masse A (112), qui est adjacente à une autre des premières lignes de signal (104) dans la troisième direction (D3), et
dans lequel les deuxièmes lignes conductrices (CL2) s'étendent longitudinalement dans la deuxième direction (D2),
dans lequel la première couche d'interconnexion (100M) comprend en outre des premiers plots (101), qui sont espacés les uns des autres dans la première direction (D1) avec les premières lignes conductrices (CL1) disposées entre eux,
dans lequel la deuxième couche d'interconnexion (110M) comprend en outre des deuxièmes plots (111), qui sont espacés les uns des autres dans la première direction (D1) avec les deuxièmes lignes conductrices (CL2) disposées entre eux,
dans lequel chacune des première et deuxième lignes conductrices (CL1, CL2) s'étend longitudinalement dans la deuxième direction (D2),
dans lequel les premières lignes conductrices (CL1) comprennent des premières lignes de masse (102) et des premières lignes de signal (104) disposées selon un premier motif d'agencement (GR1),
dans lequel les deuxièmes lignes conductrices (CL2) comprennent des deuxièmes lignes de masse (112) et des deuxièmes lignes de signal (114) disposées selon un deuxième motif d'agencement (GR2), et
dans lequel le premier motif d'agencement (GR1) est un motif dans lequel la première ligne de masse (102), la première ligne de signal (104), la première ligne de signal (104) et la première ligne de masse (102) sont disposées de manière répétée dans la première direction (D1).

2. Boîtier de semi-conducteur (1000) selon la revendication 1, dans lequel les deux premières lignes de masse (102) et les deux premières lignes de signal (104) sont disposées de manière adjacente dans l'ordre suivant : première ligne de masse (102), première ligne de signal (104), première ligne de signal (104) et première ligne de masse (102) dans la première direction (D1).

3. Boîtier de semi-conducteur (1000) selon la revendication 1 ou la revendication 2,
dans lequel les deuxièmes lignes conductrices (CL2) comprennent deux deuxièmes lignes de masse (112) incluant la deuxième ligne de masse A (112) et une deuxième ligne de masse B (112) espacées l'une de l'autre dans la première direction (D1), et la deuxième ligne de signal A (114) interposée entre elles, et
dans lequel la deuxième ligne de signal A (114) est adjacente aux deux deuxièmes lignes de masse (112).

4. Boîtier de semi-conducteur (1000) selon la revendication 1 ou la revendication 2,
dans lequel les deuxièmes lignes conductrices (CL2) comprennent deux deuxièmes lignes de masse (112), incluant la deuxième ligne de masse A (112) et une deuxième ligne de masse B (112), et deux deuxièmes lignes de signal (114), incluant la deuxième ligne de signal A (114) et une deuxième ligne de signal B (114), interposées entre elles dans la première direction (D1), et
dans lequel les deux deuxièmes lignes de signal (114) sont adjacentes l'une à l'autre.

5. Boîtier de semi-conducteur (1000) selon l'une quelconque des revendications 1-3,
dans lequel les premières lignes conductrices (CL1) sont disposées selon un premier motif d'agencement (GR1),
dans lequel les deuxièmes lignes conductrices (CL2) sont disposées selon un deuxième motif d'agencement (GR2), et
dans lequel les premier et deuxième motifs d'agencement (GR1, GR2) sont différents l'un de l'autre.

6. Boîtier de semi-conducteur (1000) selon l'une quelconque des revendications 1, 2 ou 4,
dans lequel les premières lignes conductrices (CL1) sont disposées selon un premier motif d'agencement (GR1),
dans lequel les deuxièmes lignes conductrices (CL2) sont disposées selon un deuxième motif d'agencement (GR3),
dans lequel les premier et deuxième motifs d'agencement (GR1, GR3) sont identiques, et
dans lequel les deuxièmes lignes conductrices (CL2) comprennent un motif d'agencement (GR3) décalé par rapport aux premières lignes conductrices (CL1) dans la première direction (D1).

7. Boîtier de semi-conducteur (1000) selon la revendication 6, dans lequel les deuxièmes lignes conductrices (CL2) sont décalées des premières lignes conductrices (CL1) d'une distance (01) qui est donnée comme la somme d'une largeur (104W) de la première ligne de signal (104) dans la première direction (D1) et d'une distance (X2) entre les deux premières lignes de signal (104) dans la première direction (D1).

8. Boîtier de semi-conducteur (1000) selon une quelconque revendication précédente, dans lequel une distance (L1) entre les première et deuxième couches d'interconnexion (100M, 110M) dans la troisième direction (D3) est plus grande qu'une distance (X2) entre les premières lignes de signal (104) dans la première direction (D1).

9. Boîtier de semi-conducteur (1000) selon une quelconque revendication précédente, dans lequel une distance (X1) entre une première ligne de masse (102) des deux premières lignes de masse (102) et une première ligne de signal (104) des deux premières lignes de signal (104), qui sont adjacentes l'une à l'autre, est égale à une distance (X2) entre les deux premières lignes de signal (104), qui sont adjacentes l'une à l'autre.

10. Boîtier de semi-conducteur (1000) selon l'une quelconque des revendications 1-8, dans lequel une distance (X1) entre une première ligne de masse (102) des deux premières lignes de masse (102) et une première ligne de signal (104) des deux premières lignes de signal (104), qui sont adjacentes l'une à l'autre, est inférieure à une distance (X2) entre les deux premières lignes de signal (104), qui sont adjacentes l'une à l'autre.

11. Boîtier de semi-conducteur (1000) selon la revendication 10, dans lequel une largeur (102W) de la première ligne de masse (102) dans la première direction (D1) est inférieure à une largeur (104W) de la première ligne de signal (104) dans la première direction (D1).

12. Boîtier de semi-conducteur (1000) selon la revendication 10, dans lequel une largeur (102W) de la première ligne de masse (102) dans la première direction (D1) est plus grande qu'une largeur (104W) de la première ligne de signal (104) dans la première direction (D1).

13. Boîtier de semi-conducteur (1000) selon une quelconque revendication précédente,
dans lequel la première couche d'interconnexion (100M) comprend en outre des premiers plots (101), qui sont espacés les uns des autres dans la première direction (D1) avec les premières lignes conductrices (CL1) interposées entre eux,
dans lequel la deuxième couche d'interconnexion (110M) comprend en outre des deuxièmes plots (111), qui sont espacés les uns des autres dans la première direction (D1) avec les deuxièmes lignes conductrices (CL2) interposées entre eux, et
dans lequel le boîtier de semi-conducteur (1000) comprend en outre des trous d'interconnexion (108) reliant directement les premiers plots (101) aux deuxièmes plots (111).

14. Boîtier de semi-conducteur (1000) selon la revendication 1,
dans lequel le deuxième motif d'agencement (GR2) est différent du premier motif d'agencement (GR1), et
dans lequel le deuxième motif d'agencement (GR2) est un motif dans lequel la deuxième ligne de masse (112), la deuxième ligne de signal (114) et la deuxième ligne de masse (112) sont disposées de manière répétée dans la première direction (D1).
